# EUROPÄISCHE PATENTSCHRIFT

(11) **EP 0 482 716 B1**
(45) Veröffentlichungstag und Bekanntmachung des Hinweises auf die Patenterteilung: **16.08.1995**
(21) Anmeldenummer: 91202736.4
(22) Anmeldetag: 22.10.1991
(51) Int. Cl.: H03D 3/04

(54) **FM-Demodulator**
FM-demodulator
Démodulateur-FM

(30) Priorität: 26.10.1990 DE 4034050
(43) Veröffentlichungstag der Anmeldung: 29.04.1992
(73) Patentinhaber: Philips Patentverwaltung GmbH, 22335 Hamburg (DE); Philips Electronics N.V., 5621 BA Eindhoven (NL)
(72) Erfinder: Kühn, Hans-Jürgen, W-2110 Buchholz (DE)
(74) Vertreter: von Laue, Hanns-Ulrich, Dipl.-Ing.

(56) Entgegenhaltungen:
- DE-A- 3 212 074
- DE-A- 3 917 740
- US-A- 3 783 398

## Beschreibung

Die Erfindung betrifft einen FM-Demodulator mit einem Begrenzer, in dem ein zu demodulierendes frequenzmoduliertes FM-Signal begrenzt wird, und einem Markierungsimpuls-Erzeuger, welcher in Abhängigkeit des begrenzten FM-Signals Markierungsimpulse generiert, die einem Tiefpaßfilter zugeführt werden, dessen Ausgangssignal das demodulierte Signal darstellt.

Bei derartigen FM-Demodulatoren dient der Markierungsimpuls-Erzeuger dazu, die Nulldurchgänge in dem begrenzten FM-Signal zu markieren. Es werden entweder alle Nulldurchgänge mit einem Markierungsimpuls gekennzeichnet oder nur diejenigen, die bei einer positiven oder negativen Flanke des begrenzten FM-Signals auftreten. Diese Markierungsimpulse sollen möglichst immer gleiche Breite haben, damit sie möglichst wenig Rauschen verursachen. Die Markierungsimpulse werden anschließend einem Tiefpaßfilter zugeführt, an dessen Ausgang ein Signal auftritt, welches quasi ein Maß für den Abstand der verschiedenen Markierungsimpulse, also auch für die vorliegende Modulationsfrequenz des FM-Signals ist.

Die nach dem Stande der Technik bekannten Markierungsimpuls-Erzeuger lassen sich im wesentlichen in zwei Gruppen einordnen:

Bei der ersten Gruppe dieser Markierungsimpuls-Erzeuger wird zur Generierung der Markierungsimpulse ein monostabiler Multivibrator, meist als Monoflop bezeichnet, eingesetzt. Es wird hierbei zwar die Forderung erfüllt, daß die Markierungsimpulse möglichst immer gleiche Breite haben sollen, jedoch lassen sich derartige Monoflops nicht mit der genügenden Genauigkeit in ein IC integrieren, da bei den IC-Prozessen sowohl für Widerstände als auch für Kondensatoren, mittels derer die Zeitkonstanten für einen solchen Monoflop erzeugt werden, beträchtliche Schwankungen von deren Werten auftreten. So muß für Widerstände mit Schwankungen des Widerstandswertes von ± 20 % und bei Kondensatoren mit Schwankungen deren Kapazitätwertes von ± 10 % gerechnet werden. Insgesamt ergibt sich damit bei einer IC-Herstellung eine Schwankung der Zeitkonstante von etwa 30 %. Dabei sind Temperatur-Effekte noch nicht berücksichtigt. Für das Ausgangssignal des FM-Demodulators bedeutet dies wiederum, daß je nach Exemplar und Fertigungsstreuung etwa um ± 3 dB differierende Werte auftreten, was für die meisten Anwendungen nicht tolerierbar ist. Ein FM-Demodulator, dessen Markierungsimpuls-Erzeuger mit einem Monoflop arbeitet, ist beispielsweise aus dem Fachbuch "Taschenbuch der Hochfrequenztechnik, Springer Verlag, 1969, Seiten O18 bis O19" bekannt.

Bei einer zweiten Gruppe von FM-Demodulatoren ist der Markierungsimpuls-Erzeuger in der Weise ausgelegt, daß Takte eines festen Referenztaktsignals gezählt werden. Dabei wird nach Auftreten einer Flanke des begrenzten FM-Signals mit dem nächsten Impuls des Referenztaktsignals ein Markierungsimpuls begonnen, dessen Dauer dann nach einer vorgegebenen Zahl von Takten des Referenztaktsignals wieder beendet wird. Der Nachteil dieser Lösung besteht darin, daß die Markierungsimpulse nicht gleich zu Beginn der Flanke des begrenzten FM-Signals gesetzt werden, sondern erst dann, wenn nach Auftreten dieser Flanke der nächste Impuls des Referenztaktsignals auftritt. Somit haben die Markierungsimpulse also verschiedene Lage, man kann auch sagen, sie schwanken bezüglich ihrer Phasenlage. Durch diese schwankende Phasenlage der einzelnen Markierungsimpulse wird zusätzliches Rauschen in dem FM-Demodulator erzeugt, welches auch durch Abgleich nicht zu beseitigen ist. Ein derartiger FM-Demodulator ist aus der Veröffentlichung "IEEE Journal of Solid-State Circuits Vol. SG-21, No. 6, Dezember 1986, Seiten 916 bis 922" bekannt.

Es ist Aufgabe der Erfindung, einen FM-Demodulator der eingangs genannten Art zu schaffen, welcher integrierfähig ist und gleichzeitig ein möglichst gutes Rauschverhalten aufweist.

Diese Aufgabe ist erfindungsgemäß dadurch gelöst, daß der Markierungsimpuls-Erzeuger einen Integrator und einen diesem nachgeschalteten Komparator aufweist, daß zu Beginn jeder positiven und/oder negativen Flanke des begrenzten FM-Signals ein Markierungsimpuls begonnen und der Integratoreingang wenigstens bis zum Auftauchen der nächsten positiven oder bis zum Auftauchen der nächsten negativen Flanke eines Referenztaktsignals auf ein erstes Bezugssignal geschaltet wird, daß der Integratoreingang nachfolgend in Abhängigkeit des Referenztaktsignals in einer solchen vorgegebenen Folge an das erste und an ein zweites Bezugssignal geschaltet wird, daß die dem Integrator im Verlaufe der Folge zugeführten Signale aufintegriert den Wert Null ergeben und daß innerhalb der Folge zuletzt das erste Bezugssignal auf den Integratoreingang geschaltet wird, und daß der begonnene Markierungsimpuls beendet, die laufende vorgegebene Folge abgebrochen und der Integratoreingang freigeschaltet wird, sobald mittels des Komparators detektiert wird, daß am Integratorausgang eine dort vor Beginn des Markierungsimpulses vorhandene Vergleichsspannung wieder erreicht wird.

In dem Markierungsimpuls-Erzeuger sind also ein Integrator und ein diesem nachgeschalteter Komparator vorgesehen. Es sind ferner zwei Bezugssignale vorgesehen, die verschiedene Größe haben, die jedoch jeweils konstant sind. In dem Markierungsimpuls-Erzeuger kann nun alternativ eines der beiden Bezugssignale auf den Integratoreingang geschaltet werden. Darüber hinaus besteht auch die Möglichkeit, zeitweise keines der beiden Bezugssignale auf diesen Eingang zu schalten.

Je nachdem, ob ein Markierungsimpuls mit jeder positiven, mit jeder negativen oder mit jeder Flanke des begrenzten FM-Signals erzeugt werden soll, wird im folgenden bei Auftreten einer solchen Flanke von dem Markierungsimpuls-Erzeuger sofort ein Markierungsimpuls begonnen. Gleichzeitig wird das erste Bezugssignal auf den Integratoreingang geschaltet.

Dem Markierungsimpuls-Erzeuger ist ein Referenztaktsignal zugeführt, dessen Taktfrequenz stabil ist. In Abhängigkeit dieses Referenztaktsignals bleibt der Integratoreingang wenigstens bis zum Auftauchen der nächsten positiven oder negativen Flanke des Referenztaktsignals auf das erste Bezugssignal geschaltet. Nachfolgend werden, ebenfalls in Abhängigkeit dieses Referenztaktsignals, in einer vorgegebenen Folge die beiden Bezugssignale auf den Integratoreingang geschaltet. Dabei ist zu beachten, daß die beiden Bezugssignale nie gleichzeitig auf den Eingang geschaltet werden. Es besteht die Möglichkeit, daß zeitweise auch keines der beiden Bezugssignale auf den Integratoreingang geschaltet ist. Diese vorgegebene Folge, in der die beiden Bezugssignale auf den Integratoreingang geschaltet werden, ist nun so auszulegen, daß nach Ablauf der Folge am Integratorausgang wieder die gleiche Spannung auftritt wie zu Beginn der vorgegebenen Folge. Innerhalb der Folge wird abschließend das erste Bezugssignal auf den Integratoreingang geschaltet. Dadurch, daß bereits vor Beginn dieser Folge das erste Bezugssignal bis zur ersten positiven oder negativen Flanke des Referenztaktsignals an dem Integratoreingang geschaltet wurde, wird am Ende der vorgegebenen Folge die Vergleichsspannung eher erreicht, als es der vorgegebenen Folge an sich entspräche. Um wieviel eher diese Vergleichsspannung wieder erreicht wurde, hängt davon ab, während welcher Zeitdauer das erste Bezugssignal bis zum Erreichen der ersten Flanke des Referenztaktsignals auf den Integratoreingang geschaltet war. War diese Zeitspanne in dem einen Grenzfall nahezu Null, so wird die Vergleichsspannung tatsächlich auch erst am Ende der vorgegebenen Folge wieder erreicht. Hatte diese Zeitspanne dagegen im anderen Grenzfall nahezu die Dauer einer Periode des Referenztaktsignals, so wird noch während der vorgegebenen Folge die Vergleichsspannung bereits etwa um die gleiche Dauer eher erreicht.

In jedem Falle wird zu dem Zeitpunkt, zu dem mittels des Komparators detektiert wird, daß die Spannung am Integratorausgang wieder die Vergleichsspannung erreicht hat, der bereits begonnene Markierungsimpuls beendet. Ferner wird der Integratoreingang freigeschaltet, d.h. es wird keine der Bezugssignale mehr aufgeschaltet, die laufende Folge also abgebrochen.

Bei dieser Auslegung des FM-Demodulators bzw. dessen Markierungsimpuls-Erzeugers wird die Dauer des Markierungsimpulses nur noch durch die vorgegebene Folge bestimmt. Da diese vorgegebene Folge von dem Referenztakt abhängig ist, dessen Taktfrequenz stabil ist, weisen die Markierungsimpulse immer konstante Breite auf. Auch beginnen die Markierungsimpulse immer in gewünschter Weise mit der positiven und/oder negativen Flanke des begrenzten FM-Signals. Die Zeitspanne, die ab Beginn der betreffenden Flanke des begrenzten FM-Signals und somit ab Beginn des Markierungsimpulses bis zum Auftauchen der nächsten positiven oder negativen Flanke des Referenztaktsignals auftritt, wird quasi am Ende der vorgegebenen Folge wieder dadurch kompensiert, daß um die gleiche Zeitdauer vor Ablauf der ursprünglich vorgesehenen Folge die Vergleichsspannung wieder erreicht wird. Die Zeitspanne von Beginn des Markierungsimpulses bis nur nächsten positiven oder negativen Flanke des Referenztaktsignals wird also unabhängig von ihrer Größe immer wieder kompensiert und hat keinen Einfluß auf die Dauer des Markierungsimpulses. Es ist festzulegen, ob die Folge immer mit der nächsten positiven oder immer mit der nächsten negativen Flanke des Referenztaktsignals beginnen soll.

Es sei noch erwähnt, daß es unter Berücksichtigung der beschriebenen Bedingungen völlig gleichgültig ist, wie die Folge aussieht, in der die Bezugssignale auf den Integratoreingang geschaltet werden. Es müssen nur die oben beschriebenen Bedingungen erfüllt sein. U.a. besteht auch die Möglichkeit, mit Beginn der Folge weiterhin das erste Bezugssignal auf den Integratoreingang geschaltet zu lassen und erst nach einer vorgegebenen Zahl von Flanken des Referenztaktsignals entweder den Integratoreingang freizuschalten oder auf das andere Bezugssignal zu schalten.

Bezüglich der Größe der Bezugssignale im Verhältnis zu der Vergleichsspannung gibt es grundsätzlich verschiedene Möglichkeiten, bei denen die Größe der Bezugssignale bzw. deren Differenz zu der Vergleichsspannung verschieden sein können. Es müssen jedoch bezüglich der Zeitdauer, während der die Bezugssignale auf den Integratoreingang geschaltet werden, deren Differenzen zu der Vergleichsspannung berücksichtigt werden. Sind die beiden Bezugssignale so ausgelegt, daß bei ihrem Anlegen an den Integratoreingang sich das Ausgangssignal mit jeweils der gleichen Zeitkonstante ändert, so muß die vorgegebene Folge so ausgelegt sein, daß die Bezugssignale während insgesamt gleicher Zeitdauer an den Integratoreingang geschaltet sind. Sind die beiden Bezugssignale dagegen so ausgelegt, daß beispielsweise bei Anlegen des ersten Bezugssignals die Ausgangsspannung sich mit der halben Zeitkonstante als beim Anlegen des zweiten Bezugssignals ändert, so muß während der vorgegebenen Folge das erste Bezugssignal insgesamt nur halb so lange an den Integratoreingang geschaltet sein wie das zweite Bezugssignal.

Sollen in einem Beispielsfall die beiden Bezugssignale so ausgelegt sein, daß bei ihrem Anlegen an den Integratoreingang sich dessen Ausgangsspannung mit der gleichen Steilheit, jedoch mit jeweils verschiedenen Vorzeichen, ändert und weisen die Markierungsimpulse beispielsweise eine Breite von acht Perioden des Referenztaktsignals auf, so gibt es eine Vielzahl von Möglichkeiten, nach denen die Bezugssignale auf den Integratoreingang geschaltet werden können. Eine relativ einfache Möglichkeit bestünde beispielsweise darin, nach Auftreten der ersten Flanke des begrenzten FM-Signals und nach Beginn des Markierungsimpulses zunächst ein erstes der beiden Bezugssignale auf den Integratoreingang zu schalten bis die nächste positive Flanke des Referenztaktsignals auftritt. Ab dieser Flanke könnte dann in der vorgegebenen Form beispielsweise das andere Bezugssignal während einer Zeitdauer von vier Takten also Perioden des Referenztaktsignals aufgeschaltet bleiben. Nach diesen vier Perioden des Referenztaktsignals wird dann wieder das erste Bezugssignal auf den Integratoreingang geschaltet. Nach Aufschalten dieses Bezugssignals auf den Integratoreingang wird nach einer Zeitspanne, welche vier Perioden des Referenztaktsignals abzüglich der Zeitspanne beträgt, welche zwischen Beginn des Markierungsimpulses und Aufschalten des Integratoreingangs auf das zweite Bezugssignal verstrichen ist, wieder die Vergleichsspannung erreicht, bei deren Auftreten der Komparator ein Detektorsignal abgibt, das die Beendigung des begonnenen Markierungsimpulses auslöst. Ferner wird die laufende vorgegebene Folge abgebrochen und der Integratoreingang freigeschaltet.

In diesem Beispielsfalle, in dem die Markierungsimpulse eine Breite von acht Perioden des Referenztaktsignals haben sollen, gibt es aber beispielsweise auch die Möglichkeit, innerhalb der vorgegebenen Folge das zweite Bezugssignal während zwei Perioden des Referenztaktsignals aufzuschalten, dann wären vier Perioden des Referenztaktsignals keines der beiden Bezugssignale aufzuschalten, und anschließend wieder das erste Bezugssignal bis zum Erreichen der Vergleichsspannung aufzuschalten. Darüber hinaus besteht selbstverständlich auch die Möglichkeit, innerhalb der vorgegebenen Folge mehrfach zwischen den beiden Bezugssignalen hin- und herzuschalten, wobei jedoch darauf zu achten ist, daß vor Erreichen des Endes des Markierungsimpulses die Vergleichsspannung am Integratorausgang nicht auftritt.

Der erfindungsgemäße FM-Demodulator weist ein günstiges Rauschverhalten auf, da die Markierungsimpulse gleiche Breite und auch konstante Phasenlage aufweisen. Es ist ferner der Vorteil gegeben, daß die Lage und Dauer der Markierungsimpulse nicht von Zeitkonstanten, die in der Schaltung des FM-Demodulators vorhanden sind, abhängig ist. So wirken sich differierende Zeitkonstanten des Integrators nur dahingehend aus, daß das Ausgangssignal sich verschieden schnell ändert. Da jedoch die beiden Bezugssignale im Wechsel auf den Integratoreingang aufgeschaltet werden, gleichen sich diese Effekte wieder aus, so daß also die Dauer der Markierungsimpulse nicht von differierenden Zeitkonstanten in dem Integrator abhängig ist.

Aufgrund der an dem Ausgang des Tiefpaßfilters auftretenden linearen Kennlinien weist der FM-Demodulator neben sehr gutem Rauschverhalten auch ein sehr gutes Klirrverhalten auf. Ferner ist dieser FM-Demodulator für FM-Trägerfrequenzen bis über 10 MHz einsetzbar. Da infolge der Unempfindlichkeit gegen differierende Zeitkonstanten eine völlige Abgleichfreiheit des FM-Demodulators gegeben ist, ist dieser neben Anwendungen für die Demodulation von Audiosignalen beispielsweise in Fernsehsignalen oder zur Demodulation von Videorecordersignalen auch für Meßgeräte geeignet.

Nach einer Ausgestaltung der Erfindung ist vorgesehen, daß die beiden Bezugssignale feste Bezugspotentiale darstellen, deren Werte mit jeweils gleichem Abstand über bzw. unter der Vergleichsspannung liegen und die während der vorgegebenen Folge jeweils während in der Summe gleicher Zeitspannen an den Integratoreingang geschaltet werden.

Handelt es sich bei den beiden Bezugssignalen um feste Bezugspotentiale und liegt eines der Bezugspotentiale um den gleichen Wert unterhalb der Vergleichsspannung mit dem das andere Bezugspotential über der Vergleichsspannung liegt, so ändert sich die Ausgangsspannung des Integrators jeweils mit der gleichen Zeitkonstante, wenn auch mit umgekehrtem Vorzeichen. In diesem Sonderfall ist die vorgegebene Folge so auszulegen, daß in ihr die beiden Bezugspotentiale während insgesamt der Summe jeweils gleicher Zeitdauer auf den Integratoreingang geschaltet sind. Wie oben bereits erläutert wurde, kann dies an sich in beliebigem Wechsel und auch mit Pausen geschehen, es muß jedoch die oben erwähnte Bedingung erfüllt sein.

Nach einer weiteren Ausgestaltung der Erfindung ist vorgesehen, daß die beiden Bezugssignale mittels Konstantstromquellen erzeugt werden, die Ströme gleichen Betrages jedoch verschiedenen Vorzeichens liefern, daß Vergleichsspannung den Wert Null aufweist und die Konstantstromquellen während der vorgegebenen Folge jeweils während in der Summe gleicher Zeitspannen an den Integratoreingang geschaltet werden.

Bei den Bezugssignalen kann es sich auch um konstante Ströme handeln, die mittels Konstantstromquellen erzeugt werden. Diese Ströme müssen verschiedenes Vorzeichen haben, sind jedoch bezüglich ihrer Größe insoweit grundsätzlich frei wählbar, als die Zeiten, während der sie jeweils während der vorgegebenen Folge an den Integratoreingang gelegt werden, im umgekehrten Verhältnis zu den Beträgen ihrer Werte stehen müssen. Werden die beiden Konstantstromquellen im einfachsten Fall so gewählt, daß sie gleichen Betrag jedoch verschiedenes Vorzeichen aufweisen und weist die Vergleichsspannung den Wert Null auf, so sind die Konstantstromquellen während der vorgegebenen Folge während jeweils in der Summe gleicher Zeitspannen an den Integratoreingang zu schalten.

Nach einer weiteren Ausgestaltung der Erfindung ist vorgesehen, daß mit jeder Flanke des begrenzten FM-Signals ein neuer Markierungsimpuls begonnen wird. Es tritt hierbei vor allem der Vorteil auf, daß das Tiefpaßfilter weniger steilflankig ausgeführt werden muß, da die in dem dem Tiefpaßfilter zugeführten Signal enthaltenen Störkomponenten, welche durch die Markierungsimpulse selbst erzeugt werden, bezüglich ihrer Frequenz weiter von dem Nutzsignal abliegen, das das Tiefpaßfilter an seinem Ausgang liefern soll und das quasi eine Art zeitlicher Mittelwert der Markierungsimpulse und den zwischen diesen auftretenden Pausen darstellt.

In weiter Ausgestaltung der Erfindung ist vorgesehen, daß zu Beginn jeder Flanke des begrenzten FM-Signals ein neuer Markierungsimpuls begonnen und der Integratoreingang auf das erste Bezugssignal geschaltet wird, daß nachfolgend innerhalb der vorgegebenen Folge mit der nächsten Flanke des Referenztaktsignals der Eingang des Integrators für die Dauer einer vorgegebenen Zahl von Takten des Referenztaktsignals auf das zweite Bezugssignal gelegt und anschließend wieder auf das erste Bezugssignal geschaltet wird und daß der Markierungsimpuls beendet wird, sobald der Komparator detektiert, daß das Ausgangssignal des Integrators die Vergleichsspannung erreicht hat.

Wie oben bereits erläutert wurde, gibt es eine Fülle von verschiedenen Vorgehensweisen, nach denen die beiden Bezugssignale nach Beginn eines Markierungsimpulses an den Integratoreingang geschaltet werden können. Die einfachste Vorgehensweise ist jedoch die, daß nach Beginn eines Markierungsimpulses innerhalb der vorgegebenen Folge zunächst auf ein erstes Referenzpotential geschaltet wird und daß mit Beginn der nächsten positiven Flanke des Referenztaktsignals der Integratoreingang auf das zweite Bezugspotential geschaltet wird. Dies geschieht während der Dauer einer vorgegebenen Zahl von Takten des Referenztaktsignals. Anschließend wird innerhalb der vorgegebenen Folge wieder auf das erste Bezugspotential geschaltet. Sobald der Komparator detektiert, daß das Ausgangssignal des Integrators die Vergleichsspannung erreicht hat, wird der Markierungsimpuls beendet und die laufende Folge abgebrochen.

Soll in diesem Beispielsfalle der Markierungsimpuls eine Breite von sechs Perioden des Referenztaktsignals aufweisen, so kann beispielsweise innerhalb der Folge während drei Perioden des Referenztaktsignals auf das zweite Bezugspotential geschaltet und anschließend wieder auf das erste Bezugspotential geschaltet werden.

Gemäß einer weiteren Ausgestaltung der Erfindung ist vorgesehen, daß der Eingang des Integrators über einen ersten Schalter auf das erste Bezugssignal und über einen zweiten Schalter auf das zweite Referenzsignal schaltbar ist, daß mit Beginn jedes Markierungsimpulses der erste Schalter geschlossen wird, daß mit Erreichen der nächsten positiven Flanke des Referenztaktsignals für eine vorgegebene Zahl von Takten der erste Schalter geöffnet und der zweite Schalter geschlossen wird, daß anschließend der zweite Schalter wieder geöffnet und der erste Schalter geschlossen wird und daß mit Erreichen der Vergleichsspannung am Ende des Markierungsimpulses der erste Schalter wieder geöffnet wird.

Das Umschalten des Integratoreingangs auf die beiden Bezugssignale kann mittels einfacher Schalter, insbesondere elektronischer Schalter, vorgenommen werden.

Anhand der Zeichnung wird eine Ausführungsform der Erfindung näher erläutert. Es zeigen:
Fig. 1 ein Blockschaltbild eines FM-Demodulators mit einem Markierungsimpuls-Erzeuger,
Fig. 2 ein Blockschaltbild eines Markierungsimpuls-Erzeugers eines FM-Demodulators gemäß Fig. 1 und
Fig. 3 einige über der Zeit aufgetragene Signalverläufe des Markierungsimpuls-Erzeugers gemäß Fig. 2.

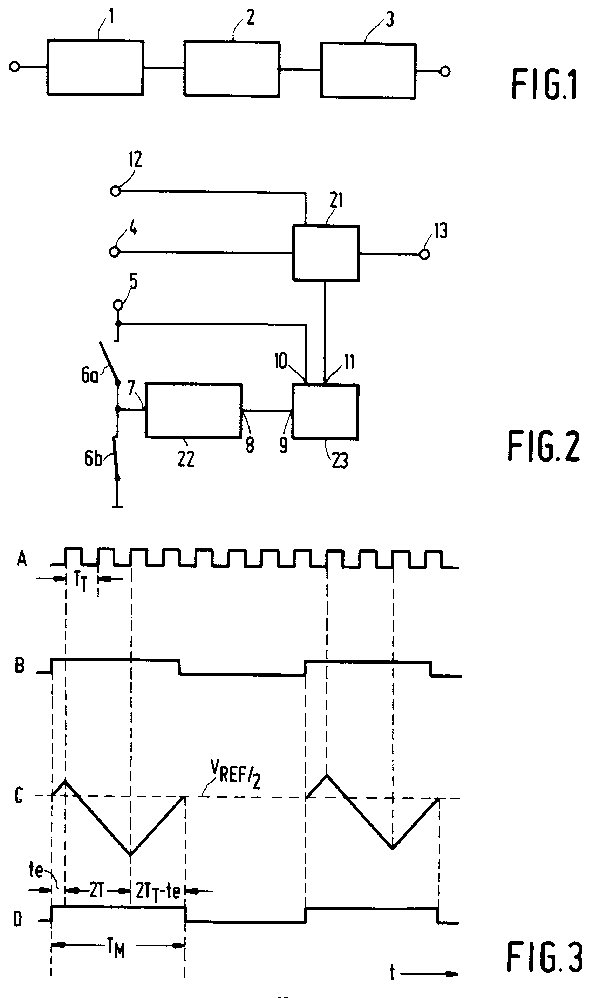

Ein in Fig. 1 dargestellter FM-Demodulator weist einen seinem Eingang nachgeschalteten Begrenzer 1 auf, in dem ein dem Eingang des FM-Demodulators zugeführtes FM-Signal bezüglich seiner Amplitude begrenzt wird. Dem Begrenzer 1 ist ein Markierungsimpuls-Erzeuger 2 nachgeschaltet, in dem bei jeder in dem begrenzten FM-Signal auftretenden Flanke ein Markierungsimpuls erzeugt wird. Hierbei bestünde auch die Möglichkeit, nur alternativ bei jeder positiven oder jeder negativen Flanke des begrenzten FM-Signals ein Markierungsimpuls zu erzeugen. Die von dem Markierungsimpuls-Erzeuger 2 erzeugten Markierungsimpulse werden einem Tiefpaßfilter 3 zugeführt, in welchem eine Tiefpaßfilterung der Markierungsimpulse in der Weise vorgenommen wird, daß am Ausgang des Tiefpaßfilters 3 ein über die Zeit gemittelter Wert der Markierungsimpulse und den zwischen ihnen auftretenden Pausen auftritt. Je höher die Frequenz des dem FM-Demodulators zugeführten Signals ist, desto geringer ist der Abstand der dem Tiefpaßfilter zugeführten Markierungsimpulse und desto höher ist also die von dem Tiefpaßfilter gelieferte Ausgangsspannung. Diese Ausgangsspannung ist also proportional zu der Momentanfrequenz des dem FM-Demodulator zugeführten FM-Trägers.

Der Markierungsimpuls-Erzeuger 2 des in der Fig. 1 dargestellten FM-Demodulators ist erfindungsgemäß gemäß dem in Fig. 2 dargestellten Blockschaltbild ausgestaltet.

Dieser in Fig. 2 dargestellte Markierungsimpuls-Erzeuger weist eine Steuerung 21, einen Integrator 22 und einen Komparator 23 auf.

Dem Markierungsimpuls-Erzeuger ist an einem ersten Eingang 4 ein begrenztes FM-Signal zugeführt, wie es in der Schaltung gemäß Fig. 1 von dem FM-Begrenzer 1 geliefert wird. Die in Fig. 2 dargestellte Schaltung weist ferner einen zweiten Eingang 5 auf, an dem dem Markierungsimpuls-Erzeuger ein festes Bezugspotential zugeführt wird. Als zweites Bezugspotential ist Masse vorgesehen. Es ist ein Schalter 6a vorgesehen, mittels dessen das dem Markierungsimpuls-Erzeuger an seinem Eingang 5 zugeführte Bezugspotential auf einen Eingang 7 des Integrators 22 schaltbar ist. Mittels eines zweiten Schalters 6b ist das zweite Bezugspotential, nämlich Masse, auf diesen Eingang 7 des Integrators 22 schaltbar. Die Steuerung der beiden Schalter 6a und 6b wird durch die Steuerung 21 vorgenommen. Das an einem Ausgang 8 des Integrators 22 auftretende Ausgangssignal wird einem Eingang 9 des Komparators 23 zugeführt. An einem weiteren Eingang 10 des Komparators wird diesem ferner das an dem Eingang 5 gelieferte feste Bezugspotential zugeführt. Der Komparator 23 ist ferner über einen Steuereingang 11 mit der Steuerung 21 verbunden. An einem weiteren Eingang 12 wird dem in Fig. 2 dargestellten Markierungsimpuls-Erzeuger ein Referenztaktsignal zugeführt, welches konstante Frequenz aufweist und beispielsweise mittels eines Quarzoszillators gewonnen worden ist. Dieses Referenztaktsignal wird innerhalb des Markierungsimpuls-Erzeugers der Steuerung 21 zugeführt. An einem Ausgang 13 liefert der Markierungsimpuls-Erzeuger die von ihm generierten Markierungsimpulse.

Im folgenden wird die Funktionsweise des in Fig. 2 dargestellten Markierungsimpuls-Erzeugers bzw. des in Fig. 1 dargestellten FM-Demodulators anhand der Fig. 3 näher erläutert. In Fig. 3 sind einige Signalverläufe des FM-Demodulators gemäß Fig. 1 und des Markierungsimpuls-Erzeugers gemäß Fig. 2 über der Zeit dargestellt.

Ein erster Kurvenverlauf A der Darstellung gemäß Fig. 3 zeigt das Referenztaktsignal, welches dem Markierungsimpuls-Erzeuger gemäß Fig. 2 an seinem Eingang 12 zur Verfügung gestellt wird. Dieses Referenztaktsignal weist eine konstante Periodendauer T_{T} auf.

Ein Kurvenverlauf B gemäß Fig. 3 zeigt ein begrenztes FM-Signal, wie es innerhalb des FM-Demodulators gemäß Fig. 1 am Ausgang des FM-Begrenzers 1 auftritt. Dem Markierungsimpuls-Erzeuger gemäß Fig. 2 wird dieses begrenzte FM-Signal an seinem Eingang 4 zur Verfügung gestellt.

Ein ferner in der Fig. 3 dargestelltes Signal C stellt das Ausgangssignal des Integrators 22 der Schaltung gemäß Fig. 2 dar.

Ein in Fig. 3 mit D bezeichnetes Signal stellt die von dem Markierungsimpuls-Erzeuger gemäß Fig. 2 an seinem Ausgang 13 gelieferten Markierungsimpulse dar. In der Darstellung gemäß Fig. 1 werden diese Markierungsimpulse von dem Markierungsimpuls-Erzeuger 2 an das Tiefpaßfilter 3 geliefert.

Mit Beginn jeder positiven Flanke des begrenzten FM-Signals B der Darstellung gemäß Fig. 3 wird von dem in dem Markierungsimpuls-Erzeuger gemäß Fig. 2 vorgesehenen Steuerung 21 sofort ein Markierungsimpuls gestartet, wie dies der Kurvenverlauf D gemäß Fig. 3 zeigt. Gleichzeitig wird mittels der Steuerung 21 der erste Schalter 6a geschlossen (der Schalter 6b ist geöffnet), so daß das dem Markierungsimpuls-Erzeuger an seinem Eingang 5 zugeführte erste, feste Bezugspotential auf den Eingang 7 des Integrators 22 geschaltet wird. Mit Auftreten der nächsten positiven Flanke des Referenztaktsignals A gemäß Fig. 3 wird der Schalter 6a wieder geöffnet und gleichzeitig der Schalter 6b geschlossen. Es beginnt damit der Ablauf einer vorgegebenen Folge, in deren Verlauf an den Eingang 7 des Integrators 22 gemäß Fig. 2 zunächst das zweite Bezugspotential, nämlich Masse, geschaltet wird. Der Kurvenverlauf C in Fig. 3 zeigt, daß das ursprüngliche ansteigende Ausgangssignal des Ausgangs 8 des Integrators 2 nunmehr abfällt. Der Schalter 6b bleibt während zwei Perioden T_{T} des Referenztaktsignals A geschlossen. Nach dieser Zeit wird im weiteren Verlauf der vorgegebneen Folge durch die Steuerung 21 der Schalter 6b wieder geöffnet und der Schalter 6a geschlossen. An dem Eingang 7 des Integrators 22 liegt nunmehr wieder das an dem Eingang 5 des Markierungsimpuls-Erzeugers anliegende Bezugspotential an. Der Kurvenverlauf C gemäß Fig. 3 zeigt, daß das am Ausgang 8 des Integrators 22 auftretende Ausgangssignal nunmehr wieder ansteigt.

Dieses Ausgangssignal C, das an dem Integrator 22 gemäß Fig. 2 an dessen Ausgang 8 auftritt, wird dem Komparator 23 gemäß Fig. 2 an seinem Eingang 9 zur Verfügung gestellt. Dem Komparator 23 gemäß Fig. 2 ist ferner das Bezugspotential, das am Eingang 5 anliegt, zugeführt. In dem Komparator 23 gemäß Fig. 2 wird dieses Bezugspotential in in der Fig. nicht näher dargestellter Weise auf den halben Wert reduziert. Dieser halbe Wert des Bezugspotentials stellt die Vergleichsspannung dar, mit der in dem Komparator 23 das von dem Integrator 22 gelieferte Ausgangssignal verglichen wird. Sobald dieses Ausgangssignal (Signal C gemäß Fig. 3) die halbe Bezugsspannung erreicht, gibt der Komparator 23 gemäß Fig. 2 ein entsprechendes Signal an die Steuerung 21, die daraufhin den Schalter 6a öffnet, den begonnenen Markierungsimpuls beendet und ablaufende vorgegebene Folge, gemäß der das erste Bezugspotential noch auf den Integratoreingang 7 geschaltet bleiben müßte, abbricht. In der Darstellung gemäß Fig. 3 ist dieses am Kurvenverlauf D erkennbar, der die erzeugten Markierungsimpulse darstellt.

In der Darstellung gemäß Fig. 3 sind zwei Markierungsimpulse dargestellt, welche beide die Zeitdauer T_{M} aufweisen. Für den ersten Markierungsimpuls des Signals D sind im Kurvenverlauf C die entsprechenden Zeiten, während der die verschiedenen Bezugspotentiale auf den Integratoreingang geschaltet sind, markiert. Während einer Zeitspanne tₑ ist zunächst das erste Bezugspotential solange auf den Integratoreingang geschaltet, bis die erste positive Flanke des Referenztaktsignals gemäß Kurvenverlauf A auftritt. Anschließend wird während zwei Perioden T_{T} das Referenztaktsignal auf das zweite Bezugspotential aufgeschaltet. Anschließend wird mit Beginn der vorgegebenen Folge wieder das erste Bezugspotential solange aufgeschaltet, bis wieder die Ausgangsspannung erreicht ist. Diese Zeitspanne beträgt dabei zwei Perioden T_{T} des Referenztaktsignals abzüglich der Zeitspanne tₑ. Gemäß der vorgegebenen Folge müßte das erste Bezugspotential während zwei Perioden T_{T} aufgeschaltet bleiben. Da jedoch bereits nach 2T_{T}-tₑ das Ausgangssignal des Integrators den Wert des Bezugspotentials erreicht, wird zu diesem Zeitpunkt der begonnene Markierungsimpuls beendet, die laufende Folge abgebrochen und der Integratoreingang freigeschaltet. Die Zeitspanne tₑ vor Beginn der vorgegebenen Folge wird also im Ergebnis immer von der Dauer der Folge wieder subtrahiert. Dies hat zur Folge, daß die Zeitdauer T_{M} des Impulses gemäß Kurvenverlauf D in jedem Falle vier Perioden T_{T} beträgt, und zwar unabhängig von der Zeitdauer tₑ. Dies wird anhand des zweiten Markierungsimpulses gemäß Kurvenverlauf D der Darstellung gemäß Fig. 3 deutlich. In dem zu diesem Markierungsimpuls gehörenden Kurvenverlauf C des Ausgangssignals des Integrators ist die Zeitspanne tₑ zwar größer als in dem zeitlich zuvor folgenden Kurvenverlauf des Ausgangssignals, gleichzeitig ist jedoch der Zeitabschnitt 2 T_{T} - tₑ entsprechend kleiner, so daß sich auch für diesen Markierungsimpuls die Zeitdauer 4 T_{T} ergibt. Mit anderen Worten ist die Breite der Markierungsimpulse nicht davon abhängig, zu welchem Zeitpunkt nach Auftreten einer positiven Flanke in dem begrenzten FM-Signal gemäß Kurvenverlauf B die nächste positive Flanke des Referenztaktsignals A auftritt. Auch bezüglich ihrer Lage weisen die Markierungsimpulse konstante Phase auf, da sie jeweils mit Beginn der positiven Flanke des begrenzten FM-Signals gemäß Kurvenverlauf B gestartet werden.

## Patentansprüche

1. FM-Demodulator mit einem Begrenzer (1), in dem ein zu demodulierendes frequenzmoduliertes FM-Signal begrenzt wird, und einem Markierungsimpuls-Erzeuger (2), welcher in Abhängigkeit des begrenzten FM-Signals Markierungsimpulse generiert, die einem Tiefpaßfilter (3) zugeführt werden, dessen Ausgangssignal das demodulierte Signal darstellt,
dadurch gekennzeichnet, daß der Markierungsimpuls-Erzeuger (2) einen Integrator (22) und einen diesem nachgeschalteten Komparator (23) aufweist, daß zu Beginn jeder positiven und/oder negativen Flanke des begrenzten FM-Signals ein Markierungsimpuls begonnen und der Integratoreingang (7) bis zum Auftauchen der nächsten positiven oder bis zum Auftauchen der nächsten negativen Flanke eines Referenztaktsignals auf ein erstes Bezugssignal geschaltet wird, daß der Integratoreingang (7) nachfolgend in Abhängigkeit des Referenztaktsignals in einer solchen vorgegebenen Folge an das erste und an ein zweites Bezugssignal geschaltet wird, daß die dem Integrator im Verlaufe der Folge zugeführten Signale aufintegriert den Wert Null ergeben und daß innerhalb der Folge zuletzt das erste Bezugssignal auf den Integratoreingang (7) geschaltet wird, und daß der begonnene Markierungsimpuls beendet, die laufende vorgegebene Folge abgebrochen und der Integratoreingang (7) freigeschaltet wird, sobald mittels des Komparators (23) detektiert wird, daß am Integratorausgang (8) eine dort vor Beginn des Markierungsimpulses vorhandene Vergleichsspannung wieder erreicht wird.

2. FM-Demodulator nach Anspruch 1,
dadurch gekennzeichnet, daß die beiden Bezugssignale feste Bezugspotentiale darstellen, deren Werte mit jeweils gleichem Abstand über bzw. unter der Vergleichsspannung liegen und die während der vorgegebenen Folge jeweils während in der Summe gleicher Zeitspannen an den Integratoreingang (7) geschaltet werden.

3. FM-Demodulator nach Anspruch 1,
dadurch gekennzeichnet, daß die beiden Bezugssignale mittels Konstantstromquellen erzeugt werden, die Ströme gleichen Betrags jedoch verschiedenen Vorzeichens liefern, daß Vergleichsspannung den Wert Null aufweist und alle Konstantstromquellen während der vorgegebenen Folge jeweils während in der Summe gleicher Zeitpsannen an den Integratoreingang (7) geschaltet werden.

4. FM-Demodulator nach einem der Ansprüche 1 bis 3,
dadurch gekennzeichnet, daß mit jeder Flanke des begrenzten FM-Signals ein neuer Markierungsimpuls begonnen wird.

5. FM-Demodulator nach einem der Ansprüche 1 bis 4,
dadurch gekennzeichnet, daß zu Beginn jeder Flanke des begrenzten FM-Signals ein neuer Markierungsimpuls begonnen und der Integratoreingang (7) auf das erste Bezugssignal geschaltet wird, daß nachfolgend innerhalb der vorgegebenen Folge mit der nächsten Flanke des Referenztaktsignals der Eingang (7) des Integrators (22) für die Dauer einer vorgegebenen Zahl von Takten des Referenztaktsignals auf das zweite Bezugssignal gelegt und anschließend wieder auf das erste Bezugssignal geschaltet wird und daß der Markierungsimpuls beendet wird, sobald der Komparator (23) detektiert, daß das Ausgangssignal des Integrators die Vergleichsspannung erreicht hat.

6. FM-Demodulator nach einem der Ansprüche 1 bis 5,
dadurch gekennzeichnet, daß der Eingang (7) des Integrators (22) über einen ersten Schalter (6a) auf das erste Bezugssignal und über einen zweiten Schalter (6b) auf das zweite Referenzsignal schaltbar ist, daß mit Beginn jedes Markierungsimpulses der erste Schalter (6a) geschlossen wird, daß mit Erreichen der nächsten positiven Flanke des Referenztaktsignals innerhalb der vorgegebenen Folge für eine vorgegebene Zahl von Takten der erste Schalter (6a) geöffnet und der zweite Schalter (6b) geschlossen wird, daß anschließend der zweite Schalter (6b) wieder geöffnet und der erste Schalter (6a) geschlossen wird und daß mit Erreichen der Vergleichsspannung dem Ende des Markierungsimpulses der erste Schalter (6a) wieder geöffnet wird.

## Claims

1. An FM demodulator comprising a limiter (1), in which a frequency-modulated FM signal to be demodulated is limited, and a marker pulse generator (2), which generates marker pulses in dependence upon the limited FM signal, which marker pulses are applied to a low-pass filter (3) whose output signal represents the demodulated signal,
characterised in that the marker pulse generator (2) comprises an integrator (22) and a comparator (23), which follows said integrator, in that at the beginning of each positive and/or negative edge of the limited FM signal a marker pulse is started and a first reference signal is applied to the integrator input (7) until the next positive or the next negative edge of a reference clock signal appears, in that the first and a second reference signal are subsequently applied to the integrator input (7) in dependence upon the reference clock signal in such a given sequence that integration of the signals applied to the integrator in the course of the sequence yields the value zero, and in that within the sequence finally the first reference signal is applied to the integrator input (7), and in that the started marker pulse is terminated, the running given sequence is interrupted and the integrator input (7) is cleared as soon as the comparator (23) detects that a comparison voltage which appears at the integrator output (8) before the beginning of the marker pulse is reached again.

2. An FM demodulator as claimed in Claim 1,
characterised in that the two reference signals represent fixed reference potentials whose values lie equidistantly above or below the comparison voltage and which are applied to the integrator input (7) in the given sequence during equal overall time intervals.

3. An FM demodulator as claimed in Claim 1,
characterised in that the two reference signals are generated by means of constant current sources which supply currents of equal magnitude but different signs, in that the comparison voltage is zero and all the constant current sources are connected to the integrator input (7) in the given sequence during equal overall time intervals.

4. An FM demodulator as claimed in any one of Claims 1 to 3,
characterised in that a new marker pulse is started at each edge of the limited FM signal.

5. An FM demodulator as claimed in any one of Claims 1 to 4,
characterised in that at the beginning of each edge of the limited FM signal a new marker pulse is started and the first reference signal is applied to the integrator input (7), in that subsequently, within the given sequence, at the next edge of the reference clock signal the second reference signal is applied to the input (7) of the integrator (2) for the duration of a given number of clock pulses of the reference clock signal and subsequently the first reference signal is applied again, and in that the marker pulse is terminated as soon as the comparator (23) detects that the output signal of the integrator has reached the comparison voltage.

6. An FM demodulator as claimed in any one of Claims 1 to 5,
characterised in that the first reference signal can be applied to the input (7) of the integrator (22) via a first switch (6a) and the second reference signal can be applied to said input via a second switch (6b), in that the first switch (6a) is closed at the beginning of each marker pulse, in that the first switch (6a) is opened and the second switch (6b) is closed for a given number of clock pulses when the next positive edge of the reference clock signal is reached within the given sequence, in that subsequently the second switch (6b) is opened again and the first switch (6a) is closed, and in that the first switch (6a) is opened again when the comparison voltage is reached at the end of the marker pulse.

## Revendications

1. Démodulateur FM avec un limiteur (1), dans lequel un signal FM modulé en fréquence à démoduler est limité, et un générateur d'impulsions de repérage (2), qui génère en fonction du signal FM limité des impulsions de repérage qui sont acheminées à un filtre passe-bas (3), dont le signal de sortie représente le signal démodulé, caractérisé en ce que le générateur d'impulsions de repérage (2) comporte un intégrateur (22) et un comparateur (23) qui y est connecté en aval, qu'au début de chaque flanc positif et/ou négatif du signal FM limité, une impulsion de repérage commence et l'entrée (7) de l'intégrateur est commutée jusqu'à l'émergence du flanc positif suivant ou jusqu'à l'émergence du flanc négatif suivant d'un signal d'horloge de référence, sur un premier signal de référence, que l'entrée (7) de l'intégrateur est commutée ensuite, en fonction du signal d'horloge de référence dans une telle séquence prédéterminée, sur le premier signal et le deuxième signal de référence, que les signaux acheminés à l'intégrateur au cours de la séquence prennent de manière intégrée la valeur zéro et que, à l'intérieur de la séquence, enfin le premier signal de référence est commuté sur l'entrée (7) de l'intégrateur, et que l'impulsion de repérage commencée se termine, la séquence prédéterminée en cours est interrompue et l'entrée (7) de l'intégrateur est libérée, aussitôt que, à l'aide du comparateur (23), on détecte qu'à la sortie (8) de l'intégrateur est atteinte à nouveau une tension de comparaison qui y était présente avant le début de l'impulsion de repérage.

2. Démodulateur FM selon la revendication 1, caractérisé en ce que les deux signaux de référence représentent des potentiels de référence fixes, dont les valeurs se situent, avec un écart chaque fois égal, au-dessus ou en dessous de la tension de comparaison et qui sont commutés sur l'entrée (7) de l'intégrateur au cours de la séquence prédéterminée, respectivement, pendant des intervalles de temps de somme égale.

3. Démodulateur FM selon la revendication 1, caractérisé en ce que les deux signaux de référence sont produits à l'aide de sources de courant constant, qui délivrent des courants de même valeur absolue, mais de signe différent, la tension de comparaison présente la valeur zéro et les sources de courant constant sont commutées sur l'entrée (7) de l'intégrateur au cours de la séquence prédéterminée, chaque fois pendant des intervalles de temps de somme égale.

4. Démodulateur FM selon l'une quelconque des revendications 1 à 3, caractérisé en ce qu'une nouvelle impulsion de repérage est amorcée à chaque flanc du signal FM limité.

5. Démodulateur FM selon l'une quelconque des revendications 1 à 4, caractérisé en ce que, au début de chaque flanc du signal FM limité commence une nouvelle impulsion de repérage et que l'entrée (7) de l'intégrateur est commutée sur le premier signal de référence, qu'ensuite, au cours de la séquence prédéterminée, au flanc suivant du signal d'horloge de référence, l'entrée (7) de l'intégrateur (22) est connectée au deuxième signal de référence pendant la durée d'un nombre prédéterminé d'impulsions d'horloge du signal d'horloge de référence, puis elle est à nouveau commutée sur le premier signal de référence, et que l'impulsion de repérage est terminée aussitôt que le comparateur (23) détecte que le signal de sortie de l'intégrateur a atteint la tension de comparaison.

6. Démodulateur FM selon l'une quelconque des revendications 1 à 5, caractérisé en ce que l'entrée (7) de l'intégrateur (22) peut être connectée via un premier commutateur (6a) au premier signal de référence et via un deuxième commutateur (6b) au deuxième signal de référence, que, au début de chaque impulsion de repérage, le premier commutateur (6a) est fermé, que, lorsque le flanc positif suivant du signal d'horloge de référence est atteint, le premier commutateur (6a) est ouvert pendant un nombre prédéterminé d'impulsions d'horloge et le deuxième commutateur (6b) est fermé, qu'ensuite le deuxième commutateur (6b) est à nouveau ouvert et le premier commutateur (6a) est fermé et que, lorsque la tension de référence est atteinte à la fin de l'impulsion de repérage, le premier commutateur (6a) est à nouveau ouvert.
